# EUROPEAN PATENT APPLICATION

(11) **EP 4 683 436 A1**
(43) Date of publication of application: **21.01.2026**
(21) Application number: 24894543.8
(22) Date of filing: 16.11.2024
(51) Int. Cl.: H05K 1/18, H05K 1/11, H01M 50/284

(54) **PCB COMPRISING CURRENT LINE ADJACENT TO BOSS HOLE**

(30) Priority: 20.11.2023 KR 20230160458
(71) Applicant: LG Energy Solution, Ltd., Seoul 07335 (KR)
(72) Inventor: KIM, Hak Soon, Daejeon 34122 (KR); JANG, Jae Young, Daejeon 34122 (KR); KANG, Dong Myung, Daejeon 34122 (KR)
(74) Representative: Plasseraud IP
(86) International application number: PCT/KR2024/018131
(87) International publication number: WO 2025/110650

(57) **Abstract**

Disclosed is a PCB including a boss hole formed in a hole shape configured to fix the PCB, wherein an electrical pattern is disposed along an inner side surface of the boss hole. Consequently, it is possible to utilize conventional PCBs without any change and to secure the allowable current as energy density increases even in increasingly constrained physical and spatial environments.

## Description

### [Technical Field]

This application claims the benefit of priority to Korean Patent Application No. 2023-0160458 filed on November 20, 2023, the disclosure of which is incorporated herein by reference in its entirety.

The present invention relates to a PCB including a current line around a boss hole. More particularly, the present invention relates to a PCB including a vertical metal plate for a current line around a boss hole for fixing the PCB to an apparatus.

### [Background Art]

In the case of a lithium secondary battery, the temperature, the voltage, and the like of a battery cell are measured and monitored for the purpose of safety. A PCB manufactured for this purpose is called a battery management unit (BMU), and an electrode lead of the battery cell is electrically connected to the PCB.

IT products such as smartphones and laptop computers are becoming smaller and lighter, whereas battery modules or battery packs used therein are becoming denser while having higher capacity. Due to the limited space available for components, the BMU is also becoming very dense. Nevertheless, for highly mobile IT products, the BMU must essentially be provided with a boss hole for fixing.

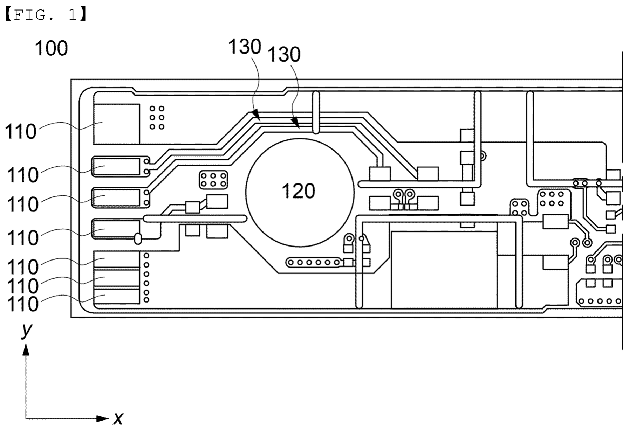

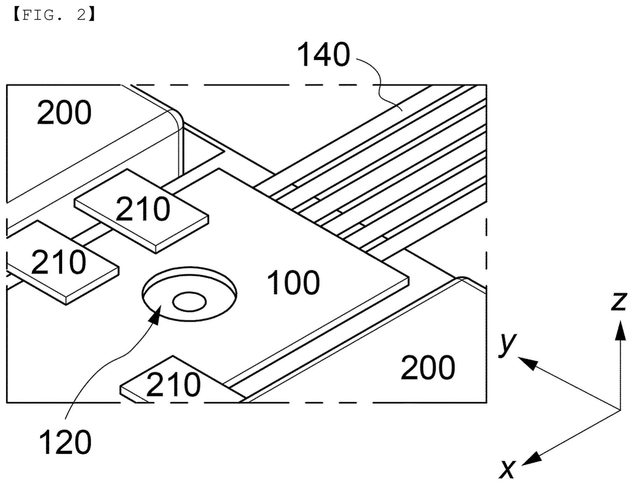

FIG. 1 is a schematic view showing a part of an upper surface of a BMU 100 according to a related art, and FIG. 2 is a perspective view showing a part of the configuration of a BMU in a battery pack according to a related art. The xyz coordinates shown in FIGs. 1 and 2 are the same. Referring to FIG. 2, a BMU 100 is disposed in the center of a battery cell 200 having electrode leads 210, and the BMU 100 is connected to external current lines 140. The BMU 100 is provided with a boss hole 120 for fixing to the battery pack. Referring to FIG. 1, a plurality of welds 110 is provided on the left side of the BMU 100. The welds 110 are welded to the external current lines 140 of FIG. 2. The electrode leads of the battery cell, a sensor, an external output terminal, and the like are welded to the welds 110. In the center of FIG. 1, the boss hole 120 for fixing the BMU 100 is provided. The welds 110 are connected to current lines 130, respectively, so as to be electrically connected to various elements in the BMU. In FIG. 1, the remainder except for the current lines 130 necessary for description is omitted.

As the boss hole 120 is provided in a horizontal plane (xy plane) of the BMU, there is not enough space for the current lines to be disposed horizontally. Since the boss hole 120 is simply a hole for fixing the BMU 100, the current lines must be disposed in the remaining area except therefor. As the width of the current lines 130 is decreased, the maximum allowable current is also reduced. As the energy density of a battery module or a battery pack is increased, the maximum allowable current must also be increased, but as the BMU becomes denser and smaller, there is less space for the current lines.

The BMU is also a multilayer PCB, but the problem that the allowable current becomes smaller still occurs. It is also impossible to dispose high-capacity current lines on an inner layer of the PCB due to heat generation. Nevertheless, with the increase in energy density, additional means capable of securing the allowable current must be provided.

Patent Document 1 relates to technology for securing electrical connection, i.e., electrical conduction, between a conductor pattern formed on a printed wiring board and a case through installation screws for fixing the printed wiring board and the case, and securing grounding, i.e., ground (GND) connection, to the case.

Patent Document 2 provides a printed wiring board having a thinned frame ground portion, wherein a frame ground portion 11 for forming conductor patterns 13a and 13b is provided around four installation holes 12 for fixing, a plurality of through-hole portions 14 is provided around the installation holes 12 for fixing the frame ground portion 11, cream solder 15 is applied to the through-hole portions 14 in a cream solder printing process in a component mounting process, the cream solder 15 is melted in a reflow process, and the molten cream solder 15 is partially introduced into the through-hole portions 14 so as to be attached to the through-hole portions 14 and the conductor patterns 13a and 13b therearound, whereby a solder film is formed.

In Patent Document 3, a screw hole 16, through which a screw 50 extends, is formed in a circuit board 10 in order to prevent the screw hole from being filled with solder without special treatment during a soldering process. No copper foil is formed on an inner wall of the screw hole 16. A first conductive portion 20 is formed around the screw hole 16 in a first main surface 12 of the circuit board 10. A head 52 of the screw 50 contacts the first conductive portion 20 and is electrically connected thereto when fixing the circuit board 10 to the case. A ground layer 28 of the circuit board 10 and the first conductive portion 20 are connected to each other in a through-hole 18. A second conductive portion is further provided on a second main surface of circuit board 10, and is electrically connected in the through-hole 18. When the screw 50 is screwed to a screw hole 62 of a fixing post 60 of a case of an electronic device, the screw 50 and the second conductive portion 22 are electrically connected to the case, whereby the ground layer 28 is electrically connected to the case.

In Patent Documents 1 to 3, as a configuration for grounding of the PCB, a conductive material is added to the inner surface of a ground hole for grounding or to upper and lower parts therearound. This is for electrical connection between the PCB and the case, which cannot be an adequate solution to the problem related to securing of current lines as in the present invention.

Patent Document 4 discloses technology for simply fixing a circular hole and a metal tube inserted thereinto electrically and physically in the form of a rivet, which cannot be a solution to the problem according to the present invention.

As such, no technology has been proposed that can utilize conventional PCBs without any change and can secure the allowable current as energy density increases even in increasingly constrained physical and spatial environments. In particular, the problem of a BMU used in IT products such as smartphones and laptop computers, which are becoming smaller and lighter while increasing energy density, must be solved.

### (Prior Art Documents)

(Patent Document 1) Japanese Patent Application Publication No. 2014-090018
(Patent Document 2) Japanese Patent Application Publication No. 2009-212124
(Patent Document 3) Japanese Patent Application Publication No. 1996-236878
(Patent Document 4) Korean Registered Patent Publication No. 2179678

### [Disclosure]

### [Technical Problem]

It is an object of the present invention to provide technology capable of utilizing conventional PCBs without any change and securing the allowable current as energy density increases even in increasingly constrained physical and spatial environments. In particular, it is another object of the present invention to provide technology capable of securing the allowable current in a BMU used in IT products such as smartphones and laptop computers, which are becoming smaller and lighter while increasing energy density.

### [Technical Solution]

In order to accomplish the above objects, the present invention provides a PCB substrate including a boss hole formed in a hole shape configured to fix the PCB, wherein an electrical pattern is disposed along an inner side surface of the boss hole. The hole shape of the boss hole may be a cylindrical shape; however, the present invention is not limited thereto. The hole shape of the boss hole may be polygonal as needed.

The electrical pattern may include a metal. The electrical pattern may be made of a conductive material. Even a paste having conductive properties may be used, but preferably copper metal, which is commonly used in the PCB, may be used.

The electrical pattern may be a thin-band-shaped metal plate made of copper used for a circuit pattern of the PCB. The band shape is disposed along the inner side surface of the boss hole. The width of the band shape may be less than the depth of the boss hole. That is, a circuit pattern of a conventional PCB is horizontally disposed on the PCB substrate. At this time, the circuit pattern may be stacked in multiple layers. On the other hand, the electrical pattern according to the present invention is characterized in that the electrical pattern is vertically disposed.

Meanwhile, the electrical pattern may have a plurality of layers. When the electrical pattern disposed along the inner side surface of the boss hole is configured to have a plurality of layers, necessary electrical patterns may be additionally disposed by the boss hole.

A connection portion may be located on an upper surface of the PCB, and the connection portion may be electrically connected to the electrical pattern. Since the electrical pattern is vertically disposed, unlike the conventional circuit pattern disposed at the PCB, the connection portion is required to connect the electrical pattern to the conventional circuit pattern. Two connection portions may be provided at a start part and an end part of the electrical pattern, respectively. The connection portion is horizontally disposed and is electrically connected to the electrical pattern.

The PCB may include a vertical gap portion extending further from the boss hole, the vertical gap portion being a vertical incised gap, and the electrical pattern may extend to the vertical gap portion. Two vertical gap portions may be symmetrically provided with respect to the boss hole, and the connection portion may be electrically connected to the electrical pattern extending to the vertical gap portion. Meanwhile, the electrical pattern may be physically fixed by the vertical gap portion.

The electrical pattern may be provided in two and disposed on left and right sides, respectively, along the inner side surface of the boss hole. The electrical pattern may include an externally exposed part that is coated with an insulating material.

The electrical pattern may be bonded to the inner side surface of the boss hole.

The electrical pattern may include a ring-shaped protective portion at the outside of the electrical pattern. The protective portion may be an insulator and may electrically separate the electrical pattern from a bolt or the like fixed through the boss hole.

The PCB may be used as a battery management unit (BMU) in a battery module.

In addition, the present invention provides a battery module including the PCB.

The present invention may provide any possible combinations of the above solving means.

### [Advantageous Effects]

The present invention provides a PCB having a boss hole formed in a hole shape for fixing the PCB substrate, wherein an electrical pattern is disposed along an inner side surface of the boss hole. Consequently, it is possible to provide technology capable of utilizing conventional PCBs without any change and securing the allowable current as energy density increases even in increasingly constrained physical and spatial environments. In addition, it is possible to provide technology capable of securing the allowable current in a BMU used in IT products such as smartphones and laptop computers, which are becoming smaller and lighter while increasing energy density.

A conventional boss hole is a non-conductor, but the electrical pattern of the present invention is added thereto. Unlike a conventional circuit pattern, the electrical pattern of the present invention is vertically disposed, and therefore it is possible to additionally provide necessary electrical patterns. The electrical pattern may have a plurality of layers. When the electrical pattern disposed along the inner side surface of the boss hole is configured to have a plurality of layers, necessary electrical patterns may be additionally disposed by the boss hole.

The electrical pattern may have a plurality of layers, or two electrical patterns may be disposed on left and right sides along the inner side surface of the boss hole, respectively. In this case, the plurality of layers or the left and right patterns may be used as separate transmission means.

### [Description of Drawings]

FIG. 1 is a schematic view showing a part of an upper surface of a BMU according to a related art.
FIG. 2 is a perspective view showing a part of the configuration of a BMU in a battery pack according to a related art.
FIG. 3 is a perspective view of a boss hole according to a first embodiment of the present invention.
FIG. 4 is a perspective view of a boss hole according to a second embodiment of the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

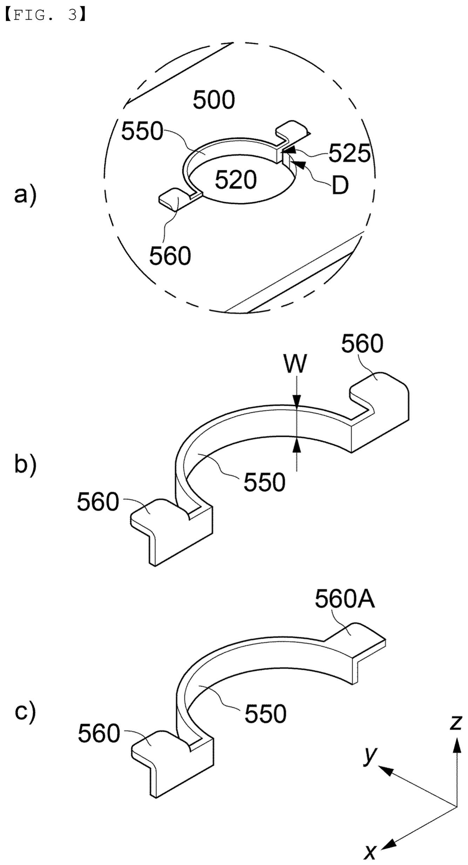

Hereinafter, a PCB according to the present invention will be described with reference to the accompanying drawings. The PCB according to the present invention differs from a conventional PCB only in terms of a boss hole and an electrical pattern disposed thereat. FIG. 3 provides perspective views of a boss hole according to a first embodiment of the present invention. FIG. 3 shows only the configuration of the boss hole and an electrical pattern disposed thereat, omitting other configurations of the PCB. a) of FIG. 3 is an enlarged view of the boss hole, b) of FIG. 3 is a view showing the electrical pattern and a connection portion, and c) of FIG. 3 is a view showing another modification of the electrical pattern.

Referring to FIG. 3, a boss hole 520 in the shape of a hole for fixing the PCB, specifically a BMU 500, and an electrical pattern 550 disposed along an inner side surface of the boss hole 520 are provided. The hole shape of the boss hole 520 is a cylindrical shape. The electrical pattern 550 is copper metal used in the PCB. The electrical pattern 550 is made of copper metal in a band shape. The band shape is disposed along the inner side surface of the boss hole. The width W of the band shape may be equal to or less than the depth D of the boss hole 520. A circuit pattern of a conventional PCB is horizontally disposed on the PCB substrate, whereas the electrical pattern 550 according to the present invention is characterized in that the electrical pattern is vertically disposed.

A connection portion 560 located on an upper surface of the BMU 500 and electrically connected to the electrical pattern 550 may be added. Since the electrical pattern 550 is vertically disposed, unlike a conventional circuit pattern disposed at the BMU, the connection portion 560 is required to connect the electrical pattern to the conventional circuit pattern. Two connection portions 560 are provided at a start part and an end part of the electrical pattern 550, respectively. The connection portion 560 is horizontally disposed and is electrically connected to the electrical pattern 550.

The connection portion 560 may be connected to the circuit pattern disposed at the conventional BMU without constituting a separate form, but since the electrical pattern 550 according to the present invention is vertically disposed, a separate connection portion 560 is provided as shown in FIG. 3, and the connection portion 560 may be connected to the circuit pattern of the conventional BMU.

A vertical gap portion 525, which is a vertical incised gap extending further from the boss hole 520, is provided, and the electrical pattern 550 extends to the vertical gap portion 525. Two vertical gap portions 525 are symmetrically provided with respect to the boss hole 520, and the connection portion 560 is electrically connected to the electrical pattern 550 extending to the vertical gap portion 525. The electrical pattern 550 is fixedly fitted in the vertical gap portion 525. c) of FIG. 3 shows a modification of one of the connection portions 560. The connection portion 560A shown in c) of FIG. 3 is directly fixed to the upper surface of the BMU 300 without the vertical gap portion 525. The connection portions 560A may be disposed at both ends of the electrical pattern 550, in which case the vertical gap portion 525 is not required.

While only one electrical pattern 550 is provided in FIG. 3, the electrical pattern may have a plurality of layers. When the electrical pattern disposed along the inner side surface of the boss hole 520 is configured to have a plurality of layers, necessary electrical patterns may be additionally disposed by the boss hole. In this case, the electrical pattern is also inserted in the vertical gap portion as a plurality of layers. However, if the electrical pattern disposed in a plurality of layers is operated as an independent circuit, a plurality of connection portions 560 must also be provided. While only one connection portion 560 is provided at each of the start part and the end part in a) of FIG. 3, a plurality of connection portions may be provided. In this case, the vertical gap portion further extends, and a plurality of connection portions 560 may be disposed adjacent to each other although electrically shortcircuited.

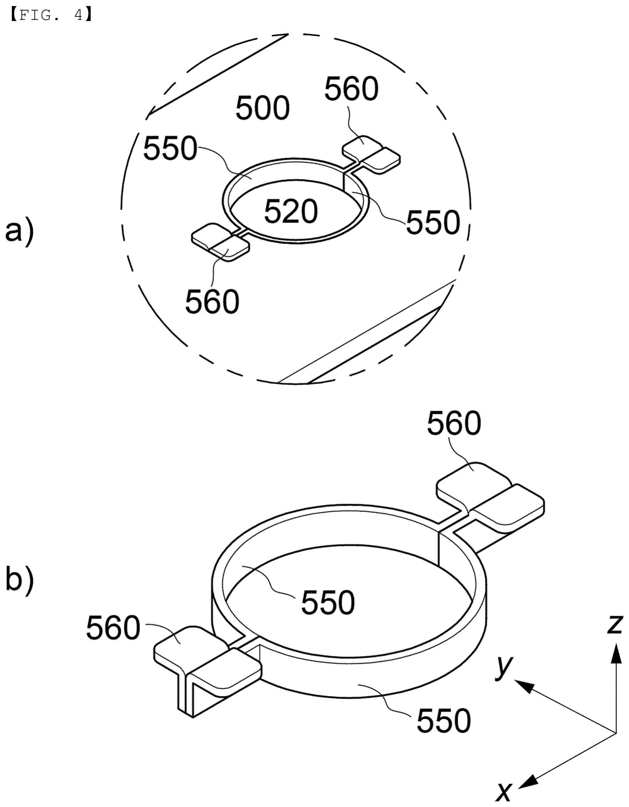

FIG. 4 provides perspective views of a boss hole according to a second embodiment of the present invention. The second embodiment is identical to the first embodiment except that two electrical patterns are disposed on left and right sides along an inner side surface of the boss hole, respectively, and therefore a description of the same configuration will be omitted.

Referring to FIG. 4, two electrical patterns 550 are disposed on left and right sides along the inner side surface of the boss hole 520, respectively. Consequently, the number of connection portions 560 is increased from two to four. The two electrical patterns 550 may constitute one electrical connection or may be used as two separate electrical connections by adding an insulator between the two electrical patterns 550.

Additionally, an externally exposed part of the electrical pattern may be coated with an insulating material, or the electrical pattern may be bonded to the inner side surface of the boss hole. In addition, a ring-shaped protective portion may be added to the outside of the electrical pattern. The protective portion may be an insulator and may electrically separate the electrical pattern from a bolt or the like fixed through the boss hole.

In addition, the present invention provides a battery module including the PCB.

Although the specific details of the present invention have been described in detail, those skilled in the art will appreciate that the detailed description thereof discloses only preferred embodiments of the present invention and thus does not limit the scope of the present invention. Accordingly, those skilled in the art will appreciate that various changes and modifications are possible, without departing from the category and the technical idea of the present invention, and it will be obvious that such changes and modifications fall within the scope of the appended claims.

### (Description of Reference Symbols)

100, 500: BMUs
110: Weld
120, 520: Boss holes
525: Vertical gap portion
130: Current line
140: External current line
200: Battery cell
210: Electrode lead
550: Electrical pattern
560, 560A: Connection portions
D: Depth of boss hole
W: Width of electrical pattern

## Claims

1. A PCB comprising:
a boss hole formed in a hole shape configured to fix the PCB substrate,
wherein an electrical pattern is disposed along an inner side surface of the boss hole.

2. The PCB according to claim 1, wherein the electrical pattern includes a metal.

3. The PCB according to claim 1, wherein the electrical pattern has a plurality of layers.

4. The PCB according to claim 1, wherein a connection portion is located on an upper surface of the PCB, and
wherein the connection portion is electrically connected to the electrical pattern.

5. The PCB according to claim 1, comprising a vertical gap portion extending further from the boss hole, the vertical gap portion being a vertical incised gap, and
wherein the electrical pattern extends to the vertical gap portion.

6. The PCB according to claim 1, wherein the electrical pattern is provided in two and disposed on left and right sides, respectively, along the inner side surface of the boss hole.

7. The PCB according to claim 1, wherein the electrical pattern includes an externally exposed part that is coated with an insulating material.

8. The PCB according to claim 1, wherein the electrical pattern is bonded to the inner side surface of the boss hole.

9. The PCB according to claim 1, wherein the electrical patter includes a ring-shaped protective portion at an outside of the electrical pattern.

10. The PCB according to claim 1, wherein the PCB is used as a battery management unit (BMU) in a battery module.

11. A battery module comprising the PCB according to any one of claims 1 to 10.
